# EUROPEAN PATENT SPECIFICATION

(11) **EP 4 257 264 B1**
(45) Date of publication and mention of the grant of the patent: **27.08.2025**
(21) Application number: 23166745.2
(22) Date of filing: 05.04.2023
(51) Int. Cl.: B22D 2/00, B22D 27/04, B22D 46/00, C30B 11/00, B22D 27/00, C30B 29/52

(54) **METHOD AND DEVICE FOR DIRECTIONAL CRYSTALISATION OF CASTINGS**
VERFAHREN UND VORRICHTUNG ZUR GERICHTETEN KRISTALLISATION VON GUSSSTÜCKEN
PROCÉDÉ ET DISPOSITIF DE CRISTALLISATION DIRECTIONNELLE DE PIÈCES COULÉES

(30) Priority: 07.04.2022 PL 44088022
(43) Date of publication of application: 11.10.2023
(73) Proprietor: Seco/Warwick S.A., 66-200 Swiebodzin (PL)
(72) Inventor: Szyc, Marcin, 66-200 Swiebodzin (PL); Piechowicz, Lukasz, 66-200 Swiebodzin (PL); Wiechczynski, Artur, 66-200 Swiebodzin (PL); Lisiewicz, Marcin, 66-100 Brzezie (PL); Dziedzic, Marcin, 31-123 Krakow (PL)
(74) Representative: Gornicki, Pawel

(56) References cited:
- WO-A1-2021/137708
- STEINBACH S ET AL: "THE INFLUENCE OF FLUID FLOW ON THE MICROSTRUCTURE OF DIRECTIONALLY SOLIDIFIED AISI-BASE ALLOYS", METALLURGICAL AND MATERIALS TRANSACTIONS A, SPRINGER US, NEW YORK, vol. 38A, no. 7, 1 July 2007 (2007-07-01), pages 1388 - 1394, XP001508233, ISSN: 1073-5623, DOI: 10.1007/S11661-007-9162-1

## Description

The subject of the invention is a device and a method for directional crystallization of castings.

The invention relates to the domain of casting production technology, in particular the treatment of molten mass in a casting mould by cooling it, and devices for such treatment, and may be applied in the production of castings from heat-resistant and creep-resistant alloys, especially in large-scale precision foundry for applications in the aviation or energy industry.

There are known methods of producing castings with oriented or monocrystalline structure using a two-chamber vacuum furnace, in which one of the chambers (upper chamber) is a heating zone, and the other (tower chamber) is a cooling zone. These methods consist of moving (extraction) a ceramic mould filled with liquid metal from the heating zone to the cooling zone, which takes place at a constant or variable speed according to a predetermined profile, called the mould extraction speed.

The most commonly used method of casting turbine blades with oriented or monocrystalline structure is the Bridgman method consisting of introducing a ceramic mould set on a cooled copper base into a heating zone, usually made as a resistance or induction heated graphite sleeve placed in a vacuum chamber, and then pouring the molten mass of the (heat-resistant and creep-resistant) superalloy from the crucible into a mould previously heated to a temperature higher than the liquidus temperature of the alloy, and moving the mould filled with liquid superalloy from the heating zone to the cooling zone through the opening of the thermal insulation partition, which is preferably a thermal partition between both zones, with the heat removal from the surface of the mould during this process through radiation, which takes place in the cooling zone below the thermal insulation partition, as a result of which a slow directional crystallization process takes place in the so-called the liquid-solid region of the alloy. A characteristic feature of this method is the use of the phenomenon of thermal radiation to cool the casting mould poured with the alloy. The said mould is moved from the heating zone to the cooling zone at a predetermined, generally constant speed, regardless of the actual temperature gradient obtained in the process in the area of the crystallization front.

The method covered by the patent US10082032 is the most extensive and has the most potential of influencing the formation of the macro-and microstructure of the casting as it takes into account various methods of process control, such as: mould speed control, cooling gas flow rate control, molten mass temperature control, which are carried out on the basis of temperature measurement using thermocouples. However, the patent relates only to the production of equiaxial castings, and the measurement method used, i.e. placing the thermocouples in the heating zone and cooling zone, is an indirect measurement in the cooling zone, not directly related to the temperature of the cooled mould and the temperature gradient in the area of the crystallization front, but dependent on many other factors, such as: the weight of the mould with the crystallizing superalloy, dimensions and geometry of the mould, distance of the thermocouple from the surface of the cast element, pressure in the furnace, etc. The result of such measurement is difficult to directly link to the temperature on the mould surface, or inside it.

A method and a device for directional crystallization of castings with oriented or monocrystalline structure are known from the Polish patent specification No. P.432486 (WO 2021/137708 A1). The known method comprises transferring to the heating zone a ceramic casting mould placed on a crystallizer connected with a vertical up-down drive mechanism, filling the mould with molten alloy from a crucible, moving the filled mould from the heating zone to the cooling zone, until the complete crystallization of the casting, which is separated from the mould after the process. While the mould containing the alloy moves from the heating zone to the cooling zone, the temperature of the mould surface is measured in real time above and below the crystallization front in at least two points. The measurement is made using contactless temperature meters. At least one of the measuring points, the lowest, is in the cooling zone. The temperature gradient value of these points is analyzed by the PLC in the feedback loop between the temperature gradient measurement system and the mould drop mechanism and / or mass or volume flow regulators that regulate the inert gas flow rates when gas blowing supports the mould cooling process. The real-time instantaneous temperature difference value is used to dynamically adjust the mould transfer speed from the heating zone to the cooling zone and / or to regulate the flow rate or gas mixture composition.

The known device for implementing the described method comprises a vacuum chamber comprising a crucible for melting the alloy and pouring the molten mass into a casting mould mounted on a cooled crystallizer and moved vertically in the up-down direction by means of a drive mechanism, and the vacuum chamber has a heating zone and a cooling zone separated by a horizontal thermal insulating partition in the form of a disc with a central opening, in the vacuum chamber at least two contactless temperature meters are installed, with at least one, the lowest, is located in the cooling zone (7). Preferably, an annular gas collector with gas ejectors supplying inert gas streams with a rate set by flow regulators is mounted in the housing of the cooling zone. Preferably, at least one contactless temperature meter is provided in the heating zone. Preferably, contactless temperature meters in a device with an installed gas manifold are arranged in such a way that the lower one is below the plane of the cooling gas supply nozzles, and the other above the plane, so that the area where the inert gas stream flowing from the annular nozzles impacts the gas manifold is located between the meters.
The location of the contactless temperature meters described above allows the measurement of the longitudinal/vertical gradient [K/cm], which is a traditional process parameter used in the industry and affecting the quality of castings.

Steinbach S. et al. in an article "The Influence of Fluid Flow on the Microstructure of Directionally Solidified AlSi-Base Alloys" (METALLURGICAL AND MATERIALS TRANSACTIONS A. SPRINGER US. New York: vol. 38A. no. 7, 1 July 2007 (2007-07:-01), p. 1388-1394, XP001508233, ISSN: 1073-5623, DOI: 10.1007/SI1661-007-9162-1) presents directional solidification process in the aerogel-based furnace facility ARTEMIS. Directional solidification from the bottom to the top heater is carried out by shifting an appropriate temperature profile along the sample. Essential to the facility is the optical control of the process parameters: due to the transparency of the crucible material. silica aerogel the movement of the solidification front during the experiments can be detected with a line charge-coupled device (CCD) camera (256 pixel, sensitivity 0.9 to 2.2 µm). From these optical measurements. the solidification velocity and the temperature gradient can be determined due to the extremely low thermal conductivity of aerogels (-0.05mW/Km), the isotherms in the sample are fiat: due to the aerogel properties, a magnetic field device could be brought very close to the sample. The magnetic field device consists of three pairs of coils around the sample powered by a three-phase current creating a homogeneous RMF: this makes possible the generation of a controlled fluid flow in the melt close to the growing solid-liquid interface. The method used does not allow for temperature measurement, further analysis and process control.

A common disadvantage of the mentioned solutions is the lack of continuous and fully automatic control of the actual transverse temperature gradient in the area of the crystallization front, and there is no observation of the shape and location of the crystallization front, i.e. the liquid-solid zone.

The indicated inconveniences caused that further trials and studies were carried out in order to develop an improved method and device.

The aim of the invention was to develop a method and a device implementing this method, allowing to optimize the production of castings, by minimizing the crystallization time in vacuum foundry furnaces by continuous observation and regulation of the temperature field in the liquid-solid zone, including the observation of the transverse (horizontal) temperature gradient and observation of the position of the liquid-solid zone. When developing the invention, it was assumed that the transverse gradient should be as small as possible, and the liquid-solid zone / crystallization front should preferably be located as close to the thermal partition as possible.

As a result of the conducted tests and trials concerning the process of casting and crystallization of aircraft engine turbine blades or power turbine blades, it was found that too large curvature of the crystallization front, equivalent to too large a transverse gradient, caused casting defects. The curvature of the crystallization front, i.e. the increase in the transverse gradient on the blade cross-section, increases with the increase in the mould extraction speed. On the other hand, it was found that the compensation of the increase in curvature caused by the increase in the mould extraction speed was the flattening of the crystallization front as a result of gas blowing onto the blades. The above conclusions from the conducted tests and trials led to the development of a new method and device for the directional crystallization of castings.

It turned out that the use of a thermal imaging camera with appropriate parameters and properly mounted, i.e. in the space near the impact of the inert gas stream flowing from the gas ejectors, would ensure the observation of the temperature spectrum distribution on the cross-section of the active part of the blade and/or its joint, which are currently being crystallized. The temperature spectrum is analyzed continuously, which enables dynamie control of inert gas blowing, aimed at obtaining the best possible homogeneous horizontal crystallization front (the smallest transverse gradient) within the airfoil blade portion and the blade joint. At the same time, on the other hand, it enables the **control of the mould extraction speed when blowing with gas, which gives the same effect of the best possible homogeneous transverse crystallization front.**

The scope of the present invention is defined by independent claims 1 and 2, and further embodiments of the invention are specified in dependent claims 3 and 4.

An unquestionable advantage of the invention is the option of using it in industrial conditions for high-performance and large-scale production of turbine blades to achieve the maximum possible furnace throughput, energy efficiency of the process while maintaining the required macro and microstructure of the casting.

Thanks to the use of continuous and automatic control of the transverse temperature gradient and the position of the liquid-solid zone, it is possible to carry out the process in the shortest time and with the required macro- and microstructure of the casting, regardless of the geometry and size of the cross-section of the cast items. If contactless temperature field measurement is used, it is possible to use the method according to the invention on an industrial scale, in every process. Then the method according to the invention does not require the use of specially prepared moulds and time-consuming procedures of installing measuring sensors on the mould.

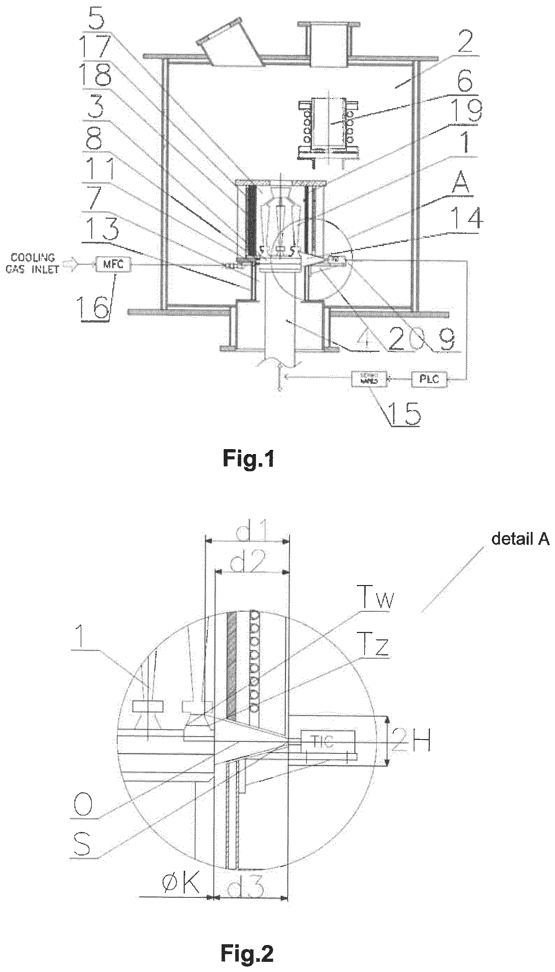

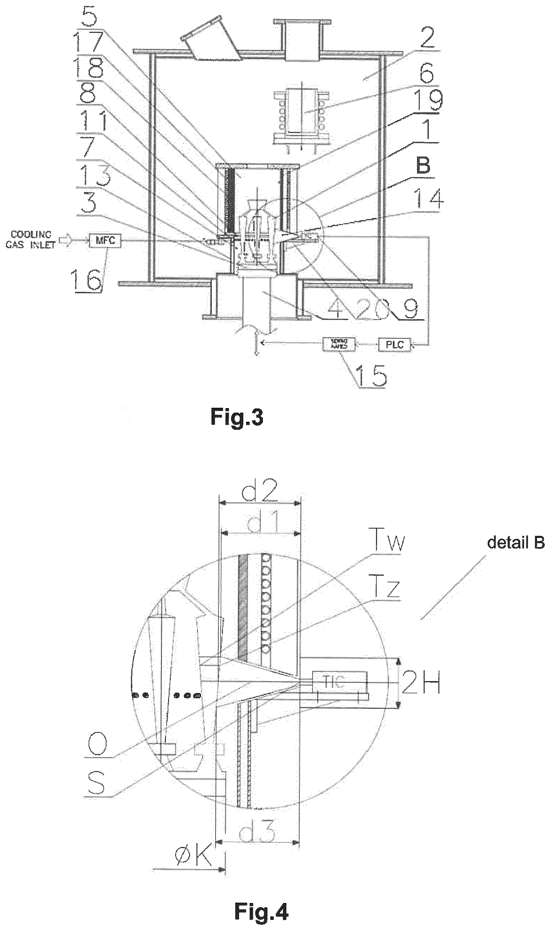

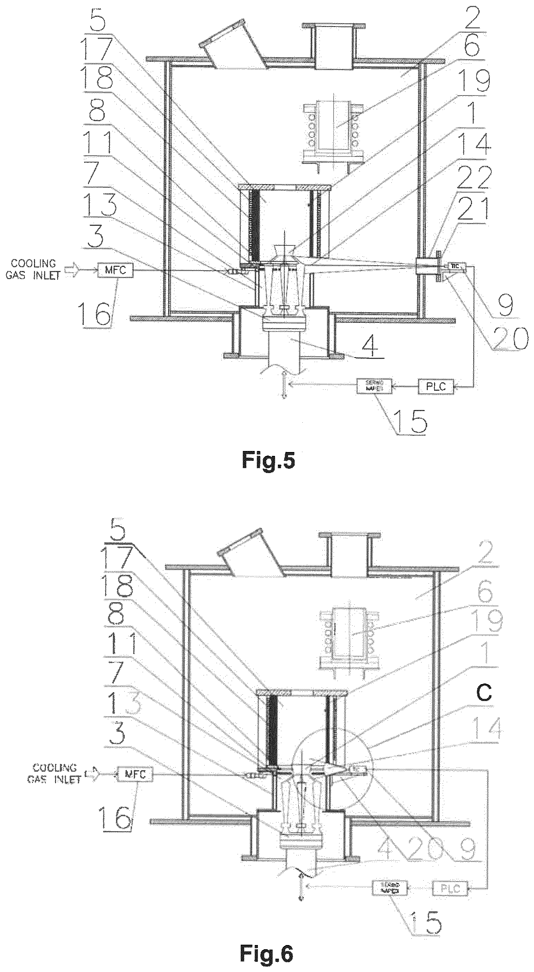

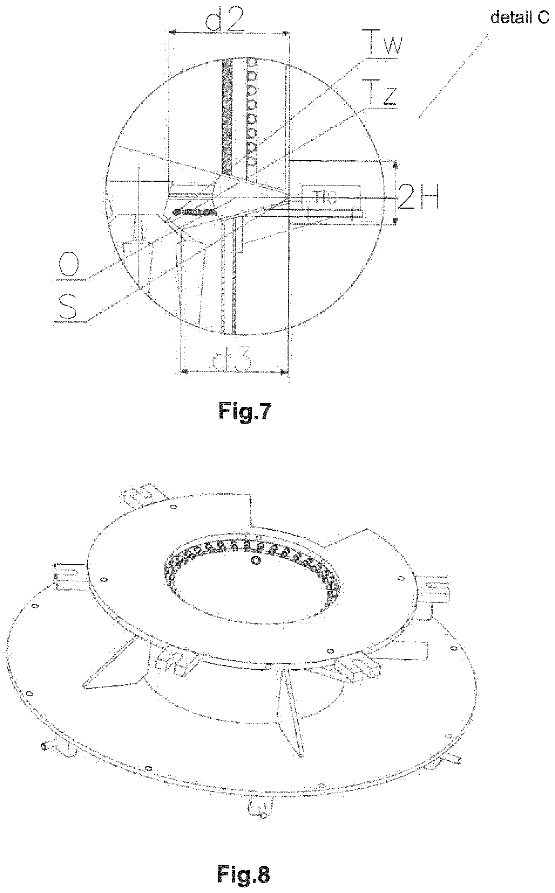

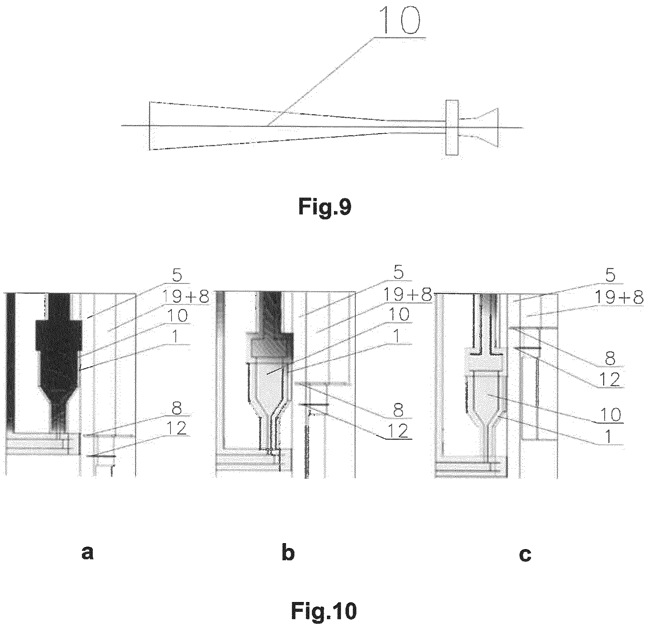

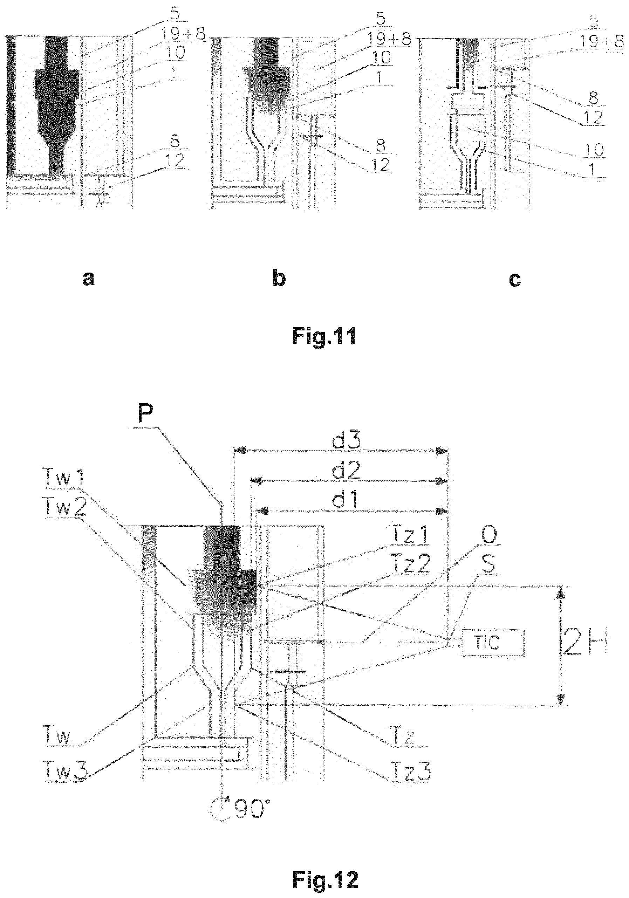

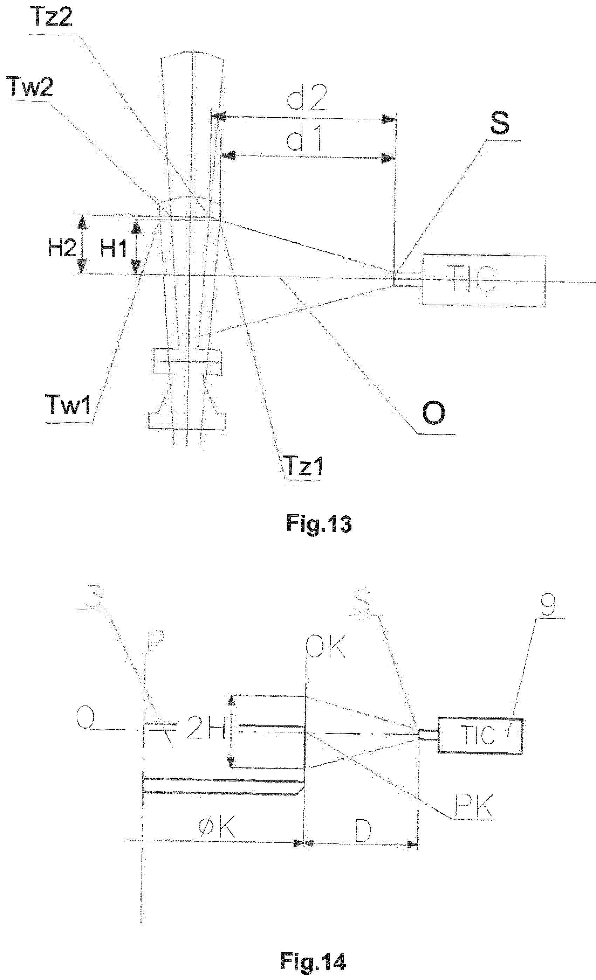

The subject of the invention, in the embodiments, is illustrated in the drawing, in which Fig. 1 shows the furnace in a longitudinal section in an embodiment in which the camera is mounted inside the vacuum chamber, with the blade-shaped mould in the upper position, completely in the heating zone with schematically marked detail A, Fig.2 shows detail A from Fig.1 with marked measurement points **Tw** and **Tz** located on the mould edges, between which the transverse temperature gradient is measured, the measurement points are located in the measurement area of the thermal imaging camera with the optical centre S and the horizontal optical axis **O** and a constant angle of view covering the liquid-solid part of the casting, , Fig.3 shows the furnace in a longitudinal section in an embodiment in which the camera is mounted inside the vacuum chamber, with the blade-shaped mould being in an intermediate position during the extraction process, partially in the heating zone and partially in the cooling zone, with schematically marked detail **B**, Fig.4 shows detail **B** from Fig. 3, Fig.5 shows the furnace with the mould in the lower position in an embodiment in which the thermal imaging camera is outside the vacuum chamber, Fig.6 shows the furnace in a longitudinal section in an embodiment in which the camera is mounted inside the vacuum chamber, with the blade-shaped mould being in the lower position during the extraction process, completely in the cooling zone, with schematically marked detail C, Fig.7 shows detail C from Fig. 6 showing the position of the thermal imaging camera in a variant in which the thermal imaging camera is inside the vacuum chamber and the mould is in the lower position, Fig.8 shows a separate cooling chamber with an annular gas manifold with gas ejectors in a perspective view, Fig.9 shows a variant of the casting in the form of a variable-geometry turbine blade, Fig.10 shows, in gray scales, the temperature distribution for the next variant of the blade casting in the process of crystallization with gas cooling and the extraction speed of 3mm/min in three positions: a) initial position as in Fig.1, the mould completely in the heating zone, metal in the liquid phase in the entire blade volume; b) an intermediate position as in Fig. 3, the mould partially in the heating zone and partially in the cooling zone, the liquid-solid zone visible, significant transverse gradient in the form of diagonal isotherms visible; c) final position as in Fig.6, the entire mould in the cooling zone, the metal crystallized in the entire blade volume. In the intermediate position, isotherms are visible that reflect the shape of the crystallization front and the liquid-solid zone, Fig. 11 a, band c show the temperature distributions for the same blade in Fig. 10 for the process with an extraction speed of 12mm/min. The isotherms visible in Fig. 11b, due to the higher extraction speed in combination with gas blowing, are more horizontal compared to the isotherms in Fig. 10b, Fig. 12 shows the blade in an intermediate position, i.e. partially in the heating zone and partially in the cooling zone, and shows the geometry of the camera's viewing angle equal to the measurement area 2H and the distances d1, d2, d3 from the camera lens optical centre to the measurement points on the mould at the heights where the pairs of measurement points Tz1-Tw1, Tz2-Tw2 and Tz3-Tw3 are located, and Fig. 13 is a diagram showing the principle of changing the distance d measured from the camera optical centre S to the measurement points on the mould edge and a half of the height of the measurement area H, depending on the position of the mould with variable geometry, and the d/H ratio remains constant, and Fig. 14 schematically shows the distance D of the camera with a fixed point of view from the outer point PK of the crystallizer at the time of installation, when the distance D is such that the height of the measurement area 2H measured along the straight line OK parallel to the crystallizer axis P and perpendicular to the optical axis O and passing through the crystallizer outer point PK is less than or equal to 200 mm.

### Embodiment 1

A device comprising a vacuum chamber **2,** in which a crucible **6** is positioned for melting the alloy and pouring the molten mass into a casting mould **1** mounted on a cooled crystallizer **3** and moved vertically up-down by means of a transfer drive **4** equipped with a servo drive **15.** The vacuum chamber has a heating zone **5** and a cooling zone **7** separated by a horizontal thermal insulating partition **8** in the form of a disk with a central opening, the heating zone **5** being formed by a graphite muffle **19** with an inducer **17** separated by a thermal insulating layer **18**. The cooling zone **7** has a cooled housing in the form of a tubular water jacket **13**, immediately below the thermal insulation partition **8**, on the circumference of the housing **13** of the cooling zone **7**, there is an annular gas collector **11** with radially arranged gas ejectors **12.** The nozzles of the gas ejectors **12** are directed towards the centre of the cooling zone **7**. Each ejector is connected to a mass flow regulator **16** regulating the flow rate of the inert gas. Everything is connected to the **PLC**. In the vacuum chamber **2**, the thermal imaging camera **9** with a measuring range of 700°C to 2000°C, resistant to vacuum and thermal conditions inside the chamber **2**, is installed on the bracket **20.** The camera's optical centre **S** is located at the height of the thermal insulation partition **8.** The distance **D** of the lens optical centre **S** of the stably mounted camera from the external point **PK** of the crystallizer **3** moving together with the mould, located on its edge in the optical axis O of the camera **9**, closest to the centre of symmetry **S** of the camera, is the height of an isosceles triangle whose base **2H** is the height of the measurement area **14.** The crystallizer **3** has a circular cross-section with a diameter K. The maximum dimension of the mould **1** does not exceed the diameter of the crystallizer. In the above device, aircraft engine turbine blades or power turbine blades **10** are made, consisting of, inter alia, the blade joint and the airfoil blade portion. Figure 9 shows a manufactured blade with an overall height of 88mm, an airfoil blade portion width of 30mm and a blade joint width of 40mm. For production, ceramic, shell moulds **1** were used, prepared by the lost wax method, with a wall thickness of 7mm +/-1 mm. The preheated casting mould **1** is placed in the vacuum chamber **2** of the furnace, on the crystallizer **3** cooled with water, using the drive **4** it is transferred along the crystallizer's vertical axis **P** to the heating zone **5** under the crucible **6.** The heating zone **5,** the cooling zone **7**, and the crucible **6** are located in the vacuum chamber **2**. The ceramic mould **1** in the heating zone **5** is heated to a temperature of 1,510°C, which is higher than the liquidus temperature of the alloy. In the crucible 6, the CMSX-4 nickel superalloy is melted, and after it is heated to a temperature above the liquidus, i.e. 1510°C, it is poured into the ceramic mould **1**, and then the mould **1** is extracted, i.e. it is transferred from the heating zone **5** through opening in the horizontal thermal insulating partition **8** to the cooling zone **7.** In the cooling zone **7**, there is a device for supplying cooling gas streams in the form of an annular gas collector **11** equipped with gas ejectors **12**, in the amount of two ejectors **12** for one single sample 10 or its other variants. From these ejectors, arranged radially on the circumference of the cooling zone **7** and inclined at an angle of 10° to the horizontal plane, an argon stream is directed at supersonic velocity onto the mould **1**, and at the same time the vacuum pump system operates in such a way that the pressure in the furnace is maintained at O,16 bar abs. The amount of argon flowing into the annular gas collector **11** is controlled by a mass valve at a constant level of 400 Ndm³/min. The transfer is carried out by the system of dynamic control of the transfer speed **4** of the mould **1** from the heating zone **5** to the cooling zone **7,** equipped with the servo drive 15. It operates continuously during the process in a closed feedback loop between the measuring system of the transverse/horizontal temperature gradient **ΔTP** in the area of the liquid-solid zone **14** based on the continuous measurement of the temperature of the mould **1** using the thermal imaging camera **9** at various heights of the mould, in the liquid-solid area, and the mould lowering mechanism, i.e. the drive **4** of the crystallizer **3** with a diameter **K,** on which the mould **1** filled with superalloy is placed. The **PLC** analyzing the instantaneous values of the temperature difference **(ΔTP=Tz-Tw)** in the liquid-solid zone, compares them with the set value of 15K and dynamically controls the transfer speed of the mould **1** in order to maintain the transverse/horizontal gradient **ΔTP** below 15K on the mould surface in the liquid-solid area. This ensures that the process is carried out in the shortest possible time and the required macro- and microstructure of the casting are maintained, regardless of the geometry and size of the cross-section of the cast items. The surface temperatures of the mould **1** in the heating zone **5** and the cooling zone **7** are measured in the form of a temperature spectrum using the thermal imaging camera **9** in the measurement area that includes 100mm above and 100mm below the thermal insulation partition **8**. The measurement area **14** is dependent on the changing shape of the casting mould. A half of the height of the measurement area is defined in Fig.13 as the heights **H1** and **H2** measured from the horizontal optical axis **O** of the camera. The heights **H1** and **H2** depend on the actual distance of the optical centre **S** of the camera **9** from the surface of the mould **1** defined as **d1** and **d2**. The H/d ratio is constant. The temperature field distribution on the surface of the mould **1** in the contour of the blade **10** is analyzed by the software of the thermal imaging camera **9** in the entire measurement area **14** (+/-100mm) and on the basis of this image, the location and shape of the liquid-solid area is determined, which for the cast metal CMSX **-4** is in the temperature range of 1320°C - 1380°C. For further calculations, the temperature gradient study area is narrowed down to the liquid-solid area. The furnace's logic controller continuously changes the mould **1** transfer speed in order to maintain the highest possible mould **1** transfer speed in the range to 50mm/min, while preventing the increase of the transverse/horizontal gradient **ΔTP** in the liquid-solid area above the set value of 15K. In the method used, eight cast blades **10** were obtained, including six castings with a monocrystalline structure and two castings with secondary grains. In addition, one blade with a monocrystalline structure had a sliver type defect, and **5** blades were free from defects. Throughout the process, the mould **1** extraction speed was within the set limit of 2-50 mm/min and the process was carried out under inert gas vacuum.

### Embodiment 2:

The device as in embodiment 1, but the vacuum chamber **2** is equipped with the additional port **22** with the sight glass **21,** on which the thermal imaging camera **9** is installed on the outer side, on the bracket **20.** In this embodiment, unlike in embodiment 1, the installed camera **9** does not have to meet the vacuum and thermal requirements inside the vacuum chamber **2.** The measurement range of the camera is the same as in embodiment 1 and is 700 - 2000°C, the measurement area is also unchanged and is in the range of about 100mm above and 100mm below the thermal insulation partition **8**. Everything is connected to the PLC.

### Embodiment 3

The system of dynamic control of the flow rates of the inert gas components operates continuously during the process in a closed feedback loop between the measuring system of the transverse/horizontal temperature gradient **ΔTP** in the liquid-solid zone **14** based on the continuous measurement of the temperature of the mould **1** using the thermal imaging camera **9** at various heights of the mould **1,** in the liquid-solid area, and the mass flow regulators **16** regulating the flow rates of the inert gas components. The PLC analyzing the instantaneous values of the temperature difference **(ΔT=Tz-Tw)** in the liquid-solid zone, compares them with the set value of 15K and controls dynamically the flow rates of the inert gas components while maintaining a constant mould transfer speed from the heating zone **5** to the cooling zone **7** in order to maintain the transverse/horizontal gradient ΔTP below 15K, guaranteeing the shortest possible time of the process and maintaining the required macro- and microstructure of the casting, regardless of the geometry and size of the cross-section of the cast items **10**. By changing the value of the flow rate of inert gas components, it is possible to affect the value of the heat flux density received from the mould surface in the area of the crystallization front **14**.

## Claims

1. A device for direction crystallization of castings, with an oriented or monocrystalline structure, comprising a vacuum chamber comprising a crucible for melting the alloy and pouring the molten mass into a casting mould mounted on a cooled crystallizer and moved vertically in the up-down direction by means of a drive mechanism, and the vacuum chamber has a heating zone and a cooling zone separated by a horizontal thermal insulating partition in the form of a disc with a central opening, and in the cooling zone there is an annular gas collector with gas ejectors supplying the chamber with inert gas streams with a rate set by flow regulators, **it is characterized in that** it is equipped with a thermal imaging camera (9), stably attached to a fixed element of the furnace, with a fixed field of view, the optical centre S and the horizontal optical axis O, directed inside the chamber, to the vertical axis P of the crystallizer (3), and the horizontal optical axis O of the camera (9) and the vertical axis P of the movable crystallizer (3) are located on one plane, and the observed measurement area (14) of the camera is at the height of the thermal partition (8) and covers the lower part of the heating zone (5) and the upper part of the cooling zone (7), and the distance D of the lens optical centre S of the stably mounted camera from the external point (PK) of the crystallizer (3) located on its edge in the optical axis O of the camera (9), closest to the centre of symmetry S of the camera, is the height of an isosceles triangle whose base 2H is the height of the measurement area (14), and the length of the base 2H of the isosceles triangle is less than or equal to 200 mm, and the camera (9) is connected to a PLC that analyses the data from the camera and is connected to the servo drive (15) of the crystallizer (3) and the mass flow regulators (16) of the gas stream in the gas ejectors (12), wherein the device is configured to record the external temperatures from Tz of the mould (1) and internal temperatures Tw of the mould (1), and configured to determine on the basis of the obtained values of Tw and Tz, the transverse temperature gradient ΔTP.

2. A method of direction crystallization of castings, with monocrystalline structure, comprising transferring to the heating zone a ceramic casting mould mounted on a cooled crystallizer connected with a vertical up-down drive mechanism, within a vacuum chamber comprising a crucible, filling the mould with molten alloy from a crucible, moving the filled mould from the heating zone to the cooling zone through a horizontal thermal insulating partition in the form of a disc with a central opening provided with an annular gas collector with ejectors supplying the chamber with a stream of gas with a regulated flow rate until the complete crystallization of the casting, which is separated from the mould after the process, wherein while the mould (1) containing the alloy moves from the heating zone (5) to the cooling zone (7) the shape of the crystallization front (the liquid-solid zone) is observed in real time using a thermal imaging camera (9), stably attached to a fixed element of the furnace, with a fixed field of view, the optical centre S and the horizontal optical axis O, directed inside the chamber, to the vertical axis P of the crystallizer (3), and the horizontal optical axis O of the camera (9) and the vertical axis P of the movable crystallizer (3) are located on one plane, and the external temperatures from Tz of the mould (1) and internal temperatures Tw of the mould (1) are recorded, and the observed measurement area (14) is located at the height of the thermal partition (8) and covers the lower part of the heating zone (5) and the upper part of the mould (1) cooling zone (7), where the distance D of the lens optical centre S of the stably mounted camera from the external point (PK) of the crystallizer (3) located on its edge in the optical axis O of the camera (9), closest to the centre of symmetry S of the camera, is the height of an isosceles triangle whose base 2H is the height of the measurement area (14), and the length of the base 2H of the isosceles triangle is less than or equal to 200 mm, and, on the basis of the obtained values of Tw and Tz, the transverse temperature gradient ΔTP is determined, which is the difference between the external temperature Tz and the internal temperature Tw at at least two heights of the mould (1), and a half of the height of the measurement area (14) defined as H for the measurement of Tz and Tw, measured from the horizontal optical axis O of the camera (9) is dependent on the actual distance d of the optical centre S from the measurement point on the mould (1) surface, then the determined values of the temperature gradient ΔTP and the values of the measured temperatures Tw and Tz are analysed using a PLC connected to the camera, located between the transverse temperature gradient measurement system and the mould lowering mechanism, and the controller is connected to the servo drive (15) and the mass flow regulators (16) that regulate the inert gas flow rates in the ejectors (12), and the instantaneous values of the transverse temperature gradient ΔTP determined in real time and the values of the measured temperatures Tz and Tw are analysed by the PLC that then sends appropriate control and/or regulating signals to the servo drive (15) and the flow regulators (16), allowing for dynamic adjustment of the speed of mould (1) movement from the heating zone (5) to the cooling zone (7) and/or dynamic control of the gas flow rate in such a way that the transverse gradient is as small as possible and the liquid-solid zone is as close as possible to the thermal partition (8).

3. A method of direction crystallization of claim 2, wherein , the thermal imaging camera (9) is mounted inside the vacuum chamber (2) to the housing (13) of the cooling zone (7) by means of the bracket (20).

4. A method of direction crystallization of claim 2, wherein, the thermal imaging camera (9) is mounted outside the vacuum chamber (2) to the furnace's outer housing by means of the bracket (20), using the additional port (22) and the sight glass (21).

## Patentansprüche

1. Vorrichtung zur gerichteten Kristallisation von Gussstücken, mit einer orientierten oder monokristallinen Struktur, einschließlich einer Vakuumkammer mit einem Tiegel zum Schmelzen der Legierung und zum Gießen der geschmolzenen Masse in eine Gussform, die auf einem gekühlten Kristallisator montiert ist und mittels eines Antriebsmechanismus vertikal von oben nach unten bewegt wird, wobei die Vakuumkammer über eine Heizzone und eine Kühlzone verfügt, die durch eine horizontale wärmeisolierende Trennwand in Form einer Scheibe mit einer zentralen Öffnung getrennt sind, und in der Kühlzone befindet sich ein ringförmiger Gassammler mit Gasausstoßern, die die Kammer mit Inertgasströmen mit einer durch Durchflussregler eingestellten Rate versorgen, **dadurch gekennzeichnet, dass** sie mit einer Wärmebildkamera (9) ausgestattet ist, die stabil an einem festen Element des Ofens angebracht ist, mit einem festen Sichtfeld, wobei das optische Zentrum S und die horizontale optische Achse O im Inneren der Kammer auf die vertikale Achse P des Kristallisators (3) gerichtet sind, und die horizontale optische Achse O der Kamera (9) und die vertikale Achse P des beweglichen Kristallisators (3) in einer Ebene liegen, und der beobachtete Messbereich (14) der Kamera sich auf der Höhe der thermischen Trennwand (8) befindet und den unteren Teil der Heizzone (5) und den oberen Teil der Kühlzone (7) abdeckt, und der Abstand D des optischen Zentrums S des Objektivs der stabil montierten Kamera von dem äußeren Punkt (PK) des Kristallisators (3), der sich an seinem Rand in der optischen Achse O der Kamera (9) befindet und dem Symmetriezentrum S der Kamera am nächsten liegt, die Höhe eines gleichschenkligen Dreiecks ist, dessen Basis 2H die Höhe der Messfläche (14) ist, und die Länge der Basis 2H des gleichschenkligen Dreiecks kleiner oder gleich 200 mm ist, und die Kamera (9) mit einer SPS verbunden ist, die die Daten der Kamera auswertet und mit dem Servoantrieb (15) des Kristallisators (3) und den Massendurchflussreglern (16) des Gasstroms in den Gasausstoßern (12) verbunden ist, wobei die Vorrichtung so konfiguriert ist, dass sie die Außentemperaturen Tz der Form (1) und die Innentemperaturen Tw der Form (1) erfasst, und so konfiguriert ist, dass sie auf der Grundlage der erhaltenen Werte von Tw und Tz den transversalen Temperaturgradienten ΔTP bestimmt.

2. Verfahren zur gerichteten Kristallisation von Gussstücken mit monokristalliner Struktur, das darin besteht, eine keramische Gussform, die auf einem gekühlten Kristallisator montiert ist, der mit einem vertikalen Aufwärts/Abwärts-Antriebsmechanismus verbunden ist, innerhalb einer Vakuumkammer mit einem Tiegel in die Heizzone zu bringen, die Form mit geschmolzener Legierung aus einem Tiegel zu füllen, die gefüllte Form von der Heizzone zur Kühlzone zu bringen und zwar durch eine horizontale wärmeisolierende Trennwand in Form einer Scheibe mit einer zentralen Öffnung, die mit einem ringförmigen Gassammler mit Gasausstoßern versehen ist, die die Kammer mit einem Gasstrom mit einer geregelten Durchflussmenge versorgen, bis zur vollständigen Kristallisation des Gussstücks, das nach dem Prozess von der Form getrennt wird, **dadurch gekennzeichnet, dass** während der Bewegung der die Legierung enthaltenden Form (1) von der Heizzone (5) zur Kühlzone (7) die Form der Kristallisationsfront (die Flüssig-Fest-Zone) in Echtzeit mit einer Wärmebildkamera (9) beobachtet wird, die stabil an einem festen Element des Ofens angebracht ist, mit einem festen Sichtfeld, wobei das optische Zentrum S und die horizontale optische Achse O im Inneren der Kammer auf die vertikale Achse P des Kristallisators (3) gerichtet sind, und die horizontale optische Achse O der Kamera (9) und die vertikale Achse P des beweglichen Kristallisators (3) in einer Ebene liegen, und die Außentemperaturen Tz der Form (1) und die Innentemperaturen Tw der Form (1) aufgezeichnet werden und der beobachtete Messbereich (14) sich auf der Höhe der thermischen Trennwand (8) befindet und den unteren Teil der Heizzone (5) und den oberen Teil der Kühlzone (7) der Form (1) abdeckt, wobei der Abstand D des optischen Zentrums S der Linse der stabil montierten Kamera von dem äußeren Punkt (PK) des Kristallisators (3), der sich an seinem Rand in der optischen Achse O der Kamera (9) befindet, die dem Symmetriezentrum S der Kamera am nächsten liegt, die Höhe eines gleichschenkligen Dreiecks ist, dessen Basis 2H die Höhe des Messbereichs (14) ist, und die Länge der Basis 2H des gleichschenkligen Dreiecks kleiner oder gleich 200 mm ist, und auf der Grundlage der erhaltenen Werte von Tw und Tz der transversale Temperaturgradient ΔTP bestimmt wird, der die Differenz zwischen der Außentemperatur Tz und der Innentemperatur Tw auf mindestens zwei Höhen der Form (1) ist, und eine Hälfte der Höhe der Messfläche (14), die für die Messung von Tz und Tw als H definiert ist, gemessen von der horizontalen optischen Achse O der Kamera (9), vom tatsächlichen Abstand d des optischen Zentrums S vom Messpunkt auf der Oberfläche der Form (1) abhängt, dann werden die ermittelten Werte des Temperaturgradienten ΔTP und die Werte der gemessenen Temperaturen Tw und Tz mit Hilfe einer an die Kamera angeschlossenen SPS ausgewertet, die zwischen dem System für die Messung des transversalen Temperaturgradienten und dem Formabsenkmechanismus angeordnet ist, und die Steuerung mit dem Servoantrieb (15) und den Massendurchflussreglern (16), die die Inertgasdurchflussmengen in den Ausstoßern (12) regeln, und die in Echtzeit ermittelten Momentanwerte des transversalen Temperaturgradienten ΔTP und die Werte der gemessenen Temperaturen Tz und Tw von der SPS ausgewertet werden, die dann entsprechende Steuer- und/oder Regelsignale an den Servoantrieb (15) und die Durchflussregler (16) sendet, die eine dynamische Anpassung der Geschwindigkeit der Bewegung der Form (1) von der Heizzone (5) zur Kühlzone (7) und/oder eine dynamische Steuerung des Gasdurchsatzes ermöglichen, so dass der transversale Gradient so gering wie möglich ist und die Flüssig-Fest-Zone so nahe wie möglich an der thermischen Trennwand (8) liegt.

3. Verfahren zur gerichteten Kristallisation nach Anspruch 2, **dadurch gekennzeichnet, dass** die Wärmebildkamera (9) innerhalb der Vakuumkammer (2) mit Hilfe der Halterung (20) am Gehäuse (13) der Kühlzone (7) befestigt wird.

4. Verfahren zur gerichteten Kristallisation nach Anspruch 2, **dadurch gekennzeichnet, dass** die Wärmebildkamera (9) außerhalb der Vakuumkammer (2) mit Hilfe der Halterung (20) unter Verwendung der zusätzlichen Öffnung (22) und des Schauglases (21) am Außengehäuse des Ofens befestigt wird.

## Revendications

1. Un dispositif de cristallisation directionnelle de pièces coulées avec une structure orientée ou monocristalline, comprenant une chambre sous-vide comportant un creuset pour la fonte de l'alliage et le versement de la masse fondue dans un contre-moule installé sur un cristallisateur refroidi et déplacé verticalement dans la direction haut-bas par le moyen d'un mécanisme d'entrainement, et la chambre sous-vide possédant une zone chauffante et une zone refroidissante séparées par une cloison isolante horizontale en forme de disque avec une ouverture centrale, la zone refroidissante comportant un collecteur de gaz annulaire avec des éjecteurs de gaz alimentant la chambre avec des flux de gaz inerte à un débit réglé par les régulateurs de flux, il est **caractérisé en ce qu'**il est équipé d'une caméra thermique (9), solidement connecté à un élément fixe du four, avec un champ de vision fixe, le centre optique S et l'axe optique horizontal O, orienté à l'intérieur de la chambre vers l'axe vertical P du cristalliseur (3), et l'axe optique horizontal O de la caméra (9) et l'axe vertical P du cristalliseur mobile (3) se trouvent sur un niveau, et la zone de mesure surveillée (14) de la caméra se trouve à hauteur de la cloison thermique (8) et couvre la partie inférieure de la zone chauffante (5) et la partie supérieure de la zone refroidissante (7), et la distance D des lentilles du centre optique S de la caméra solidement fixée du point externe (PK) du cristalliseur (3) situé sur le bord dans l'axe optique O de la caméra (9), plus près du centre de symétrie S de la caméra, est la hauteur d'un triangle isocèle dont la base 2H étant la hauteur de la zone de mesure (14), et la longueur de la base 2H du triangle isocèle étant inférieure ou égale à 200 mm, et la caméra (9) étant connectée à un API qui analyse les données de la caméra et qui est connecté au servomoteur (15) du cristalliseur (3) et aux régulateurs de flux de masse (16) du flux de gaz dans les éjecteurs de gaz (12), où le dispositif est configuré de manière à enregistrer les températures extérieures Tz du moule (1) et les températures extérieures Tw du moule (1), et configuré de manière à déterminer sur la base des valeurs Tw et Tz obtenues, le gradient de température transversal ΔTP.

2. Un procédé de cristallisation directionnelle de pièces coulées, avec une structure monocristalline, comprenant un transfert vers la zone chauffante un contre-moule céramique monté sur un cristalliseur refroidi connecté avec un mécanisme d'entrainement haut-bas, à l'intérieur d'une chambre sous-vide comportant un creuset, remplissant le moule avec l'alliage fondu du creuset, déplaçant le moule rempli de la zone chauffante vers la zone refroidissante à travers une cloison thermique horizontale en forme de disque avec une ouverture centrale dotée d'un collecteur de gaz annulaire avec des éjecteurs alimentant la chambre d'un jet de gaz à un débit réglé jusqu'à la cristallisation complète de la pièce coulée, qui est séparé du moule après le procédé, où, lorsque le moule (1) contenant l'alliage est déplacé de la zone chauffante (5) vers la zone refroidissante (7), la forme de l'avant de cristallisation (la zone liquide-solide) est observée en temps réel à l'aide d'une caméra thermique (9), solidement raccordée à l'élément fixe du four, avec un champ de vision défini, le centre optique S et l'axe optique horizontal O, orienté à l'intérieur de la chambre, vers l'axe vertical P du cristalliseur (3), et l'axe optique horizontal O de la caméra (9) et l'axe vertical P du cristalliseur mobile (3) se trouvant sur un niveau, et les températures extérieures Tz du moule (1) et les températures intérieures Tw du moule (1) étant enregistrées, et la zone de mesure surveillée (14) étant située à hauteur de la cloison thermique (8) et couvrant la partie inférieure de la zone chauffante (5) et la partie supérieure du moule (1) dans la zone refroidissante (7), où la distance D des lentilles du centre optique S de la caméra solidement fixée du point externe (PK) du cristalliseur (3) situé sur le bord dans l'axe optique O de la caméra (9), plus près du centre de symétrie S de la caméra, est la hauteur d'un triangle isocèle dont la base 2H étant la hauteur de la zone de mesure (14), et la longueur de la base 2H du triangle isocèle étant inférieure ou égale à 200 mm, et, sur la base des valeurs Tw et Tz obtenues, le gradient de température transversal ΔTP est déterminé, ce qui correspond à la différence entre la température extérieure Tz et la température intérieure Tw à au moins deux hauteurs du moule (1), et à moitié de hauteur de la zone de mesure (14) définie comme H pour la mesure de Tz et de Tw, mesuré à partir de l'axe optique horizontal O de la caméra (9), il dépend de la distance actuelle d du centre optique S du point de mesure de la surface du moule (1), puis les valeurs déterminées du gradient de température ΔTP et les valeurs des températures Tw et Tz sont analysé à l'aide d'un API connecté à la caméra, placé entre le système de mesure du gradient de température transversal et le mécanisme d'abaissement du moule et l'automate étant connecté au servomoteur (15) et aux régulateurs du flux de masse (16) qui régulent le débit de gaz inerte dans les éjecteurs (12), et les valeurs instantanées du gradient de température transversal ΔTP déterminées en temps réel et les valeurs des températures Tz et Tw mesurées sont analysées par l'API qui envoie par la suite les signaux adéquats de commande et/ou de réglage au servomoteur (15) et aux régulateurs de flux (16), permettant un réglage dynamique de la vitesse de déplacement du moule (1) de la zone chauffante (5) vers la zone refroidissante (7) et/ou la commande dynamique du débit de gaz de manière à ce que le gradient transversal soit le plus faible possible et que la zone liquide-solide soit le plus proche possible de la cloison thermique (8).

3. Un procédé de cristallisation directionnelle de la revendication 2 où la caméra thermique (9) est fixée à l'intérieur de la chambre sous-vide (2) à la structure (13) de la zone refroidissante (7) à l'aide d'un support (20).

4. Un procédé de cristallisation directionnelle de la revendication 2 où la caméra thermique (9) est fixée à l'extérieur de la chambre sous-vide (2) à la structure externe du four, à l'aide d'un support (20), avec l'utilisation d'un port supplémentaire (22) et d'un indicateur de niveau (21).
